# NEUE EUROPÄISCHE PATENTSCHRIFT

(11) **EP 1 095 836 B2**
(45) Veröffentlichungstag und Bekanntmachung des Hinweises auf die Entscheidung über den Einspruch: **10.02.2010**
(45) Hinweis auf die Patenterteilung: 20.08.2003
(21) Anmeldenummer: 00122929.3
(22) Anmeldetag: 21.10.2000
(51) Int. Cl.: B61D 27/00, H05K 7/20

(54) **Unterflurcontainer für Schienenfahrzeuge**
Underfloor container for rail vehicles
Boîtier sous plancher pour véhicules ferroviaires

(30) Priorität: 26.10.1999 DE 19951356
(43) Veröffentlichungstag der Anmeldung: 02.05.2001
(73) Patentinhaber: Daimler AG, 70327 Stuttgart (DE)
(72) Erfinder: Drabon, Rodscha, 68535 Edingen-Neckarshausen (DE)
(74) Vertreter: Broydé, Marc

(56) Entgegenhaltungen:
- DE-A- 3 805 005
- DE-A- 4 223 647
- DE-A- 19 632 053

## Beschreibung

Die Erfindung bezieht sich auf einen Unterflurcontainer eines Schienenfährzeuges für elektrische Komponenten gemäß dem Oberbegriff der Ansprüche 1 und 9. Ein solcher Container ist z.B. aus der Schrift " U-Bahn der zweiten Generation von Typ B für die Verkehrsbetriebe Märchen " von F. Feiertag, W. Biel und G. Scholtis, Georg Siemens Verlagsbuchhandlung, 1982 bekannt. Der erfindungsgemäße Container dient zur Aufnahme von Stromrichtergeräten.

Bei Schienenfahrzeugen, insbesondere bei Nahverkehrsfahrzeugen, ist es bekannt, Stromrichtergeräte und dazugehörige Komponenten in einem Container zu installieren, der im Unterflurbereich, im Dachbereich oder in einem Maschinenraum des Fahrzeugs montiert ist. Bekannte derartige Container sind aus Bleche gefertigt, die entsprechend den Endabmessungen des Containers zugeschnitten sind, wobei vergleichsweise kostenaufwendige Konstruktionen erforderlich sind, um die notwendige mechanische Stabilität und Dichtigkeit der Container gegen Feuchtigkeit und Staub sicherzustellen.

Auch ist es bekannt, beim Bau solcher Container Wandungsteile aus Aluminiumstrangpressprofilen herzustellen, welche im Wege des Strangpressens hergestellte offene Nuten aufweisen. Die dabei erzeugten stegartigen und im fertiggestellten Gehäuse umlaufenden Ansätze dienen in erster Linie der mechanischen Stabilität des fertiggestellten Containers und auch der Verlegung elektrischer Leitungen.

Bei Schienenfahrzeugen für den schweren Nahverkehr, z. B. S- und U-Bahnen, müssen bei Unterflurgeräten maximal mögliche Bauhöhen berücksichtigt werden. Sie werden in Zukunft bei etwa 450 mm liegen. Diese Randbedingung erschwert es aus konstruktiver Sicht erheblich, Schienenfahrzeuge für den schweren Nahverkehr mit leistungsstarken Unterflurgeräten auszurüsten.

Die Aufgabe der Erfindung besteht darin, einen Unterflurcontainer der eingangs genannten Art zu schaffen, der in der Lage ist, Stromrichtergeräte und zugehörige Baukomponenten für den schweren Nahverkehr in Unterflurbauweise aufzunehmen.

Diese Aufgabe ist gemäß einem ersten Aspekt der Erfindung durch den Gegenstand des Anspruchs 1 gelöst.

Die Erfindung zeigt einen Weg auf, wie Unterflurcontainer ausgebildet und anzuordnen sind, um auch für relativ große Antriebsleistungen entsprechend große Abmessungen aufweisende Stromrichtergeräte für Schienenfahrzeuge des schweren Nahverkehrs und deren zugehörige Komponenten derart vorsehen zu können, daß bei der erforderlichen Leistung eine Unterfluranordnung möglich ist. Die erfindungsgemäße Aufteilung des Unterflurcontainers in mehrere Einzelcontainer und die erfindungsgemäße Anordnung in thermischer Hinsicht in Reihe hintereinander gewährleisten eine einwandfreie Abführung der Verlustwärme der elektrischen Komponenten aus den Einzelcontainern und ermöglichen so die erforderliche kompakte Bauweise des Containers.

Gemäß einem zweiten Aspekt der Erfindung ist vorgesehen, dass ein erster, ein zweiter und ein dritter Einzelcontainer mittels Tragschienen miteinander verbunden sind und dass die Tragschienen zur Befestigung des Unterflurcontainers an dem Schienen Fahrzeug dienen. Die jeweils erforderliche räumliche Zuordnung einzelner Einzelcontainer zueinander kann an den Tragschienen variabel gestaltet werden.

Gemäß der Erfindung ist weiterhin vorgesehen, daß in einem ersten Einzelcontainer ein Lüfter angeordnet ist, daß an gegenüberliegenden Seiten des ersten Einzelcontainers je ein weiterer (zweiter und dritter) Einzelcontainer vorhanden ist, daß an einer dritten Seite des Einzelcontainers ein vierter Einzelcontainer vorgesehen ist und daß die Einzelcontainer Lüftungsöffnungen aufweisen und induziert vom Lüfter hierdurch von Kühlluft durchströmt werden.

Es hat sich gezeigt, daß bei dieser erfindungsgemäßen Variante der Erfindung eine besonders effektive Führung der Kühlluft gewährleistet ist, was Voraussetzung für die angestrebte niedrige Bauhöhe des erfindungsgemäßen Unterflurcontainers ist.

Wenn in Weiterführung des Grundgedankens der Erfindung vorgesehen ist, daß die Einzelcontainer im wesentlichen gleiche Bauhöhe aufweisen, so dient dies der Möglichkeit einer preiswerten Herstellung des erfindungsgemäßen Unterflurcontainers. Durch die vorgegebenen gleichen Bauhöhen für sämtliche Einzelcontainer, lassen sich die Fertigungskosten sowie die Lagerhaltung für alle Einzelcontainer optimieren.

Es liegt auch im Rahmen der Erfindung, wenn die Einzelcontainer Wandungen aus Strangpressprofilen mit offenen und geschlossenen Kanälen aufweisen. Diese erfindungsgemäße Konstruktion erbringt - in bekannter Weise - eine vergleichsweise robuste Bauweise auch der Einzelcontainer. Darüber hinaus können aber die geschlossenen Kanäle mit Vorteil zur Zwangsführung von Kühlluft innerhalb der Einzelcontainer herangezogen werden. Die Abführung der Verlustwärme erfolgt dann nicht nur durch die letztendlich aus dem erfindungsgemäßen Unterflurcontainer ausströmende, vom Lüfter induzierte Luftströmung, sondern auch durch Wärmeaustausch an den Außenflächen der Einzelcontainer, begünstigt durch den Fahrtwind, bei Bewegung des mit dem erfindungsgemäßen Unterflurcontainer ausgerüsteten Schienenfahrzeugs.

Weitere Einzelheiten, Merkmale und Vorteile der Erfindung ergeben sich aus der folgenden Beschreibung eines bevorzugten Ausführungsbeispiels, den Patentansprüchen sowie anhand der schematischen Zeichnung. Es zeigen:
- Fig. 1: den erfindungsgemäßen Unterflurcontainer in perspektivischer Darstellung;
- Fig. 2: den Gegenstand der Fig. 1 in Draufsicht;
- Fig. 3: den Gegenstand der Fig. 1 in einer Seitenansicht;
- Fig. 4: den erfindungsgemäßen Unterflurcontainer gemäß Fig. 1 in einer Stirnansicht;
- Fig. 5: ein Ersatzschaltbild einer erfindungsgemäßen thermischen Reihenschaltung von Einzelcontainern des erfindungsgemäßen Unterflurcontainers.
- Fig. 6: ein Strangpreßprofil im Schnitt senkrecht zur Preßrichtung;
- Fig. 7: einen Einzelcontainer in perspektivischer Darstellung;
- Fig. 8: einen Kantenbereich eines Einzelcontainers und
- Fig. 9: einen Schnitt längs der Ebene I-I der Fig. 7.

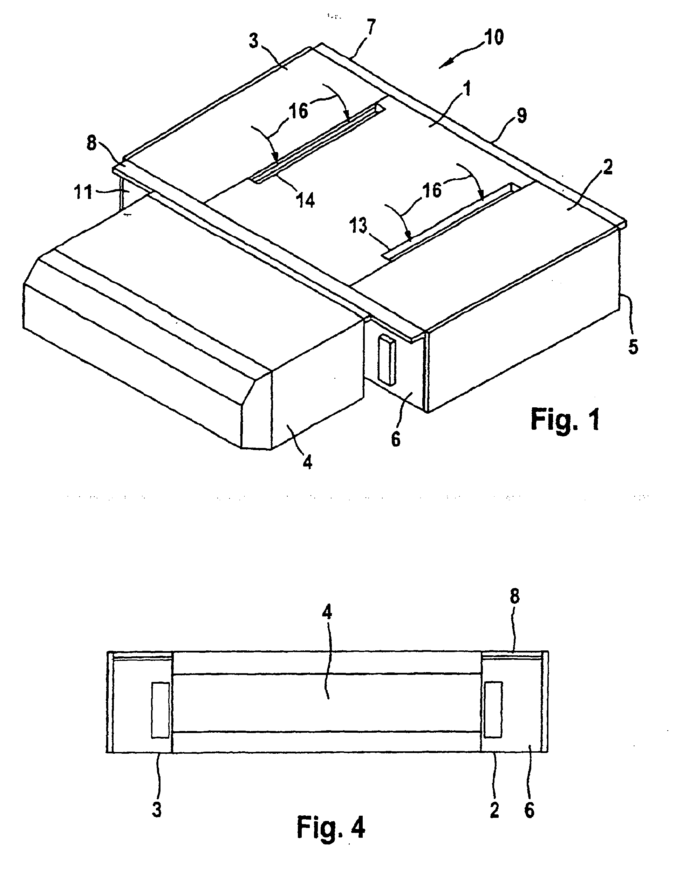

In Fig. 1 ist ein Unterflurcontainer 10 gemäß der Erfindung schaubildlich dargestellt. Er besteht aus einem ersten Einzelcontainer 1, einem zweiten Einzelcontainer 2, einem dritten Einzelcontainer 3 sowie einem vierten Einzelcontainer 4. Der Aufbau dieser Einzelcontainer 1 bis 4 wird unten noch näher erläutert.

Wie sich aus den Fig. 1 bis 4 ergibt, sind die Einzelcontainer 1 bis 4 mechanisch miteinander verbunden. Beim gezeichneten Ausführungsbeispiel sind die Einzelcontainer 1 bis 3 an ihren beiden Schmalseiten 5 und 6 mittels Winkelprofilteilen 7 und 8 miteinander verbunden, an denen sie mechanisch befestigt sind. Stege 9 und 11 dieser Winkelprofile können zur Befestigung des gezeigten Unterflurcontainers an dem mit ihm auszurüstenden Schienenfahrzeug dienen. Zweckmäßigerweise geschieht dies mittels einer dort vorgesehenen Einschubführung und/oder über Überschraubverbindungen, wobei in den Stegen 9 und 11 entsprechende Ausnehmungen zum Durchstechen von Schrauben vorgesehen sind.

Wie die Fig. 1 bis 3 weiter zeigen, ist über den Steg 11 des Winkelprofilteils 8 der Einzelcontainer 4 an dem über die Winkelprofilteile 7 und 8 zusammengefaßten Einzelcontainem 1,2 und 3 fest angeordnet. Hierzu dient ein zunächst am Einzelcontainer 4 angeordnetes weiteres Winkelprofilteil 12, das einerseits mechanisch fest mit dem Einzelcontainer 4 sowie dem Steg 11 des Winkelprofilteils 6 verbunden ist. Auf diese Weise ergibt sich eine mechanisch feste Verbindung zwischen den vier Einzelcontainem 1 bis 4. Dieser Einzelcontainer 4 kann jedoch auch separat am Fahrzeugboden angefügt sein (keine mechanisch haltende Verbindung zum Winkelprofilteil 8). Thermisch ist dieser Einzelcontainer 4 jedoch an die Einzelcontainer 1,2 und 3 gekoppelt.

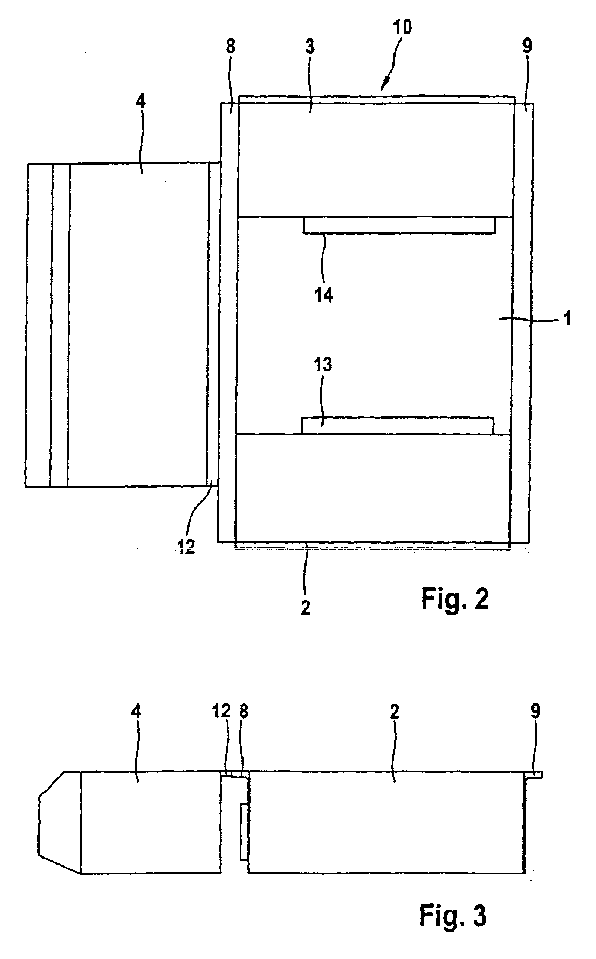

Gemäß Fig. 1 und 2 ist der Einzelcontainer 3 mit schlitzförmigen Lüftungsöffnungen 13 und 14 versehen. Auf diese Weise wird über einen im Einzelcontainer 1 angeordneten Lüfter 15 Luft als Kühlmittel angesaugt und über Kühlrippen der Einzelcontainer 2 und 3 transportiert; vgl. Pfeile 16. Die Lüftungsöffnungen 13 und 14 stehen mit den Einzelcontainern 2 und 3 in Verbindung. Von dort strömt die angesaugte Luft über nicht gezeigte Lüftungsöffnungen in den Einzelcontainer 1.

Die Einzelcontainer 1 und 4 weisen an ihren einander gegenüberliegenden Flächen sowie die dort angeordneten Winkelprofilteile 8 und 12 nicht gezeigte Öffnungen auf, durch die vom Lüfter 15 in den Einzelcontainer 1 gesaugte Luft anschließend die Kühlung eines dort u. U. angeordnete elektrische Bauteile in den Einzelcontainer 4 strömt und dort weitere elektrische Komponenten, z.B. Bremswiderstände, kühlen kann. Die dort angelangte Kühlluft kann dann aus dem Einzelcontainer 4 austreten und den erfindungsgemäßen Unterflurcontainer 10 verlassen.

Der Einzelcontainer 1 und die hieran angrenzenden Einzelcontainer 3 und 2 sind ebenfalls an ihren aneinander anliegenden Wandungen mit nicht dargestellten Öffnungen versehen, so daß Kühlluft aus den Einzelcontainern 3 und 2 zur Kühlung der dort angeordneten Baukomponenten anschließend in den Einzelcontainer 1 strömen kann. Die weitere Luftführung kann so ausgestaltet sein, daß die aus den Einzelcontainern 3 und 2 in den Einzelcontainer 1 eingeführte Kühlluft entweder direkt nach Einzelcontainer 1 in die Umgebung abgeführt wird oder daß sie über im einzelnen ebenfalls nicht gezeigte Führungskanäle noch in den Einzelcontainer 4 strömt und dort die weitere Kühlung von Bauelementen unterstützt, um erst aus dem Einzelcontainer 4 abgeführt zu werden.

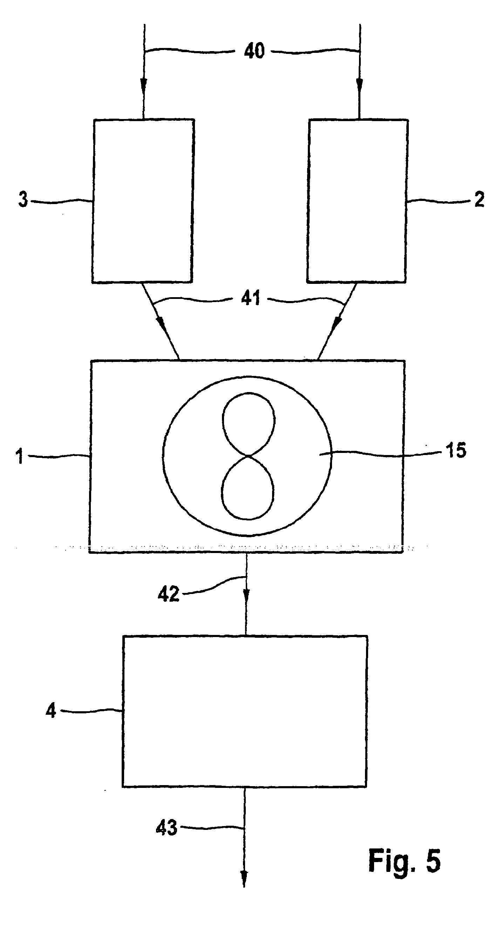

In Fig. 5 ist das strömungstechnische Ersatzschaltbild für den in den Fig. 1 bis 4 gezeigten Unterflurcontainer 10 wiedergegeben. Entsprechend den Pfeilen 40 strömt vom Lüfter 15 angesaugte Luft durch die Einzelcontainer 2, und von dort über Verbindungen 41 zwischen den Einzelcontainern 3 und 1 bzw. 2 und 1 in den Einzelcontainer 1. Der Lüfter 15 ist beim gezeigten Ausführungsbeispiel im Einzelcontainer 1 vorgesehen. Grundsätzlich könnte er aber ebenso beispielsweise im Einzelcontainer 4 vorgesehen sein. Vom Einzelcontainer 1 strömt über weitere Verbindungen/Öffnungen 42 das Kühlmedium Luft in den Einzelcontainer 4 und von dort aus tritt es dann, wie der Pfeil 43 zeigt, aus dem Unterflurcontainer 10 in die Außenluft aus.

In den Einzelcontainern sind, wie erwähnt, elektrische Komponenten vorgesehen. So können beispielsweise in den Einzelcontainern 2 und 3 Wechselrichter, im Einzelcontainer 1 neben dem Lüfter 15 eine oder mehrere Drosseln und im Einzelcontainer 4 ein oder mehrere Bremswiderstände angeordnet sein.

Dieses Ersatzschaltbild zeigt die Führung des Kühlluftstromes im erfindungsgemäßen Unterflurcontainer. Die zu kühlenden Komponenten werden somit der Reihe nach von der Kühlluft durchströmt, trotz ihrer konstruktiven Anordnung gemäß den Fig. 1 bis 4. Die Einzelcontainer 2 und 3 sind bezüglich der Luftströmung parallel geschaltet. In ihrer Kombination bilden sie jedoch das Eingangsglied für die Reihenschaltung des gesamten Kühlluftstroms.

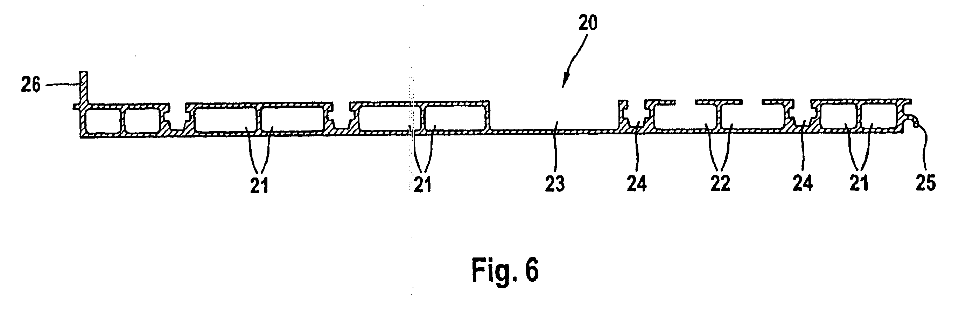

Fig. 6 zeigt im Schnitt ein Strangpreßprofil 20 zur Herstellung der Einzelcontainer 1 bis 3. Es sind in erster Linie geschlossene Kühlmittelkanäle 21, Kabelkanäle 22, ein Kanal 23 zur Aufnahme von Stromschienen, Nuten 24 zur Befestigung von gehäuseintemen Einbauteilen, z.B. Zwischenwänden, eine deckelseitige Kante 25 zur Einhängung eines Deckelscharniers und ein rückwandseitiger Flansch 26 zu erkennen. Des weiteren ist ein Dichtkragen 39 zu erkennen.

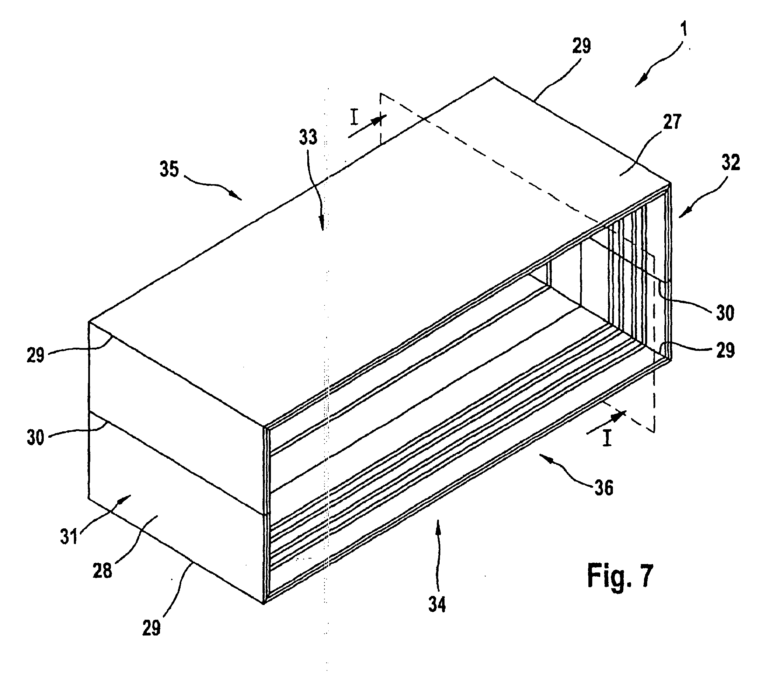

Fig. 7 zeigt eine perspektivische Darstellung eines Einzelcontainers am Beispiel des Einzelcontainers 2 bzw. 3. Er ist aus vier Hauptkomponenten zusammengesetzt, nämlich einem Oberteil 27, einem Unterteil 28, wobei Rückwand und Deckel nicht dargestellt sind. Das Oberteil 27 bildet mit dem Unterteil 28, den Seitenflächen 31 und 32 sowie der Dach- und Bodenfläche 33 und 34 den Einzelcontainer 2 bzw. 3. Die Rückwand bzw. der Deckel sind aus flachen Blechen, vorzugsweise aus Aluminium, gebildet, und verschließen die Rückseite 35 bzw. die Vorderseite 36 des Einzelcontainers 1. Das Oberteil 27 wie auch das Unterteil 28 bestehen im wesentlichen aus dem nachstehend im einzelnen beschriebenen Aluminium-Strangpreßprofil nach Fig. 6. Bei kleinerer Ausführung des Einzelcontainers 1 (bis 3) kann auch eine Variante verwendet werden, wobei das Oberteil 27 und Unterteil 28 zu einem einzigen Teil zusammengefaßt sind. Sowohl bei der einteiligen wie auch bei der zweiteiligen Ausführung, bei der Unter- und Oberteil 27, 28 vorgesehen sind, erfolgt die Verbindung der Aluminium-Strangpreßprofile vorzugsweise nicht im Kantenbereich 29, sondern längs einer Seitenfläche 31, 32.

Sowohl das Oberteil 27 als auch das Unterteil 28 des Einzelcontainers 1 sind jeweils einstückig U-förmig gebogen. Die zur Herstellung verwendeten Aluminium-Strangpreßprofile 20 müssen zunächst bearbeitet und danach um 90° abgebogen werden, um die jeweils rechtwinkligen Abwinkelungen in den Kantenbereich 29 zu ermöglichen. Zur Erzielung der gewünschten mechanischen Stabilität sind die Kantenbereiche vorzugsweise verschweißt oder unter Einsatz passender Winkelstücke verschraubt. Die Verbindung von Oberteil 27 und Unterteil 28 kann an deren Stirnflächen 30 vorzugsweise durch Verschweißen erfolgen.

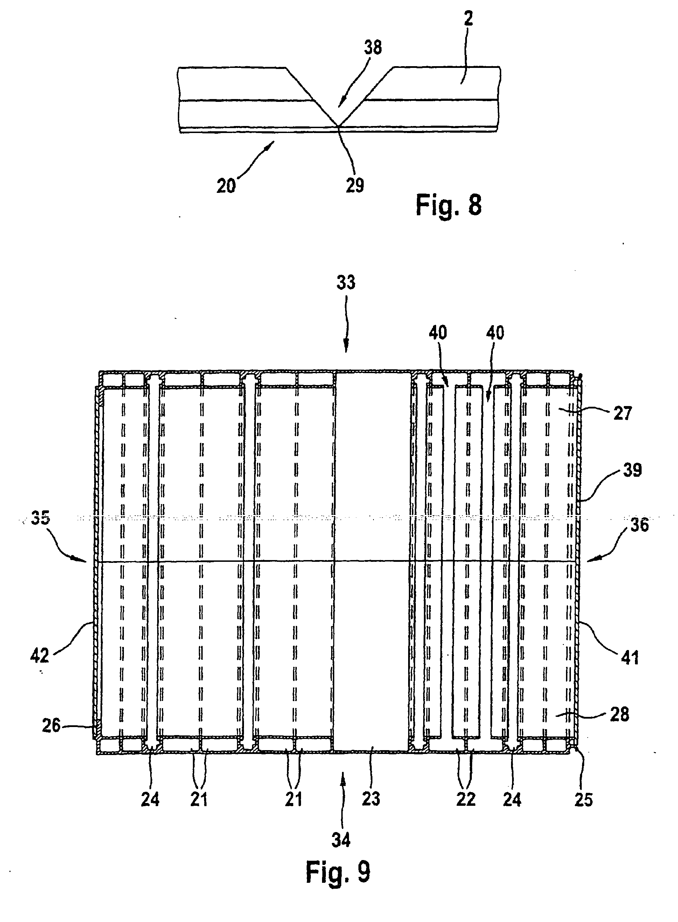

In Fig. 8 ist hierzu am Beispiel des Oberteils 27 die Bearbeitung des Aluminium-Strangpreßprofils 20 zur Schaffung eines Kantenbereichs 29 dargestellt. Die Aluminium-Strangpreßprofile 20 werden in den Kantenbereichen 29 quer zur Preßrichtung bis zur Grundmaterialstärke mit einem rechtwinkligen, V-förmigen Einschnitt 38 versehen, vorzugsweise durch Fräsen.

Fig. 9 zeigt einen Schnitt durch den Einzelcontainer von Fig. 7 entlang der Schnittebene I - I. Das zur Bildung der Seitenflächen 31, 32, der Dachfläche 33 und der Bodenfläche 34 eingesetzte Aluminium-Strangpreßprofil 20 besitzt eine genau an die Erfordernisse des Einzelcontainers 1 angepaßte Struktur mit mindestens einem Kühlmittelkanal 21, mindestens einem Kabelkanal 22, mindestens einem Kanal 25 zur Aufnahme von Stromschienen, mindestens einer Nut 24 zur Befestigung von gehäuseinternen Zwischenwänden, einer deckelseitigen Kante 25 zur Einhängung eines Deckelscharniers, einem deckelseitigen Dichtkragen 39 und einem rückwandseitigen Flansch 26.

Der mindestens eine Kühlmittelkanal 21 ist mit geschlossenem Querschnitt versehen und an den Kantenbereichen 29 vorzugsweise durchgehend verbunden, wobei die Abdichtung im Kantenbereich 29 bei Einsatz von Luft als Kühlmittel mittels Dichtmasse erfolgen kann. Mit Hilfe der Kühlmittelkanäle 21 wird ein geräteinterner Kühlkreislauf, vorzugsweise Luft-Kühlkreislauf, gebildet Die in einzelnen im Innenraum des Containers installierten Komponenten produzierte und abgestrahlte Wärmeenergie wird durch den geräteinternen Kühlkreislauf aufgenommen und über die Oberfläche des Containers an die Außenatmosphäre abgegeben. Hierdurch wird die Entstehung unzulässig hoher Temperaturen innerhalb des Einzelcontainers 1 verhindert.

Der mindestens eine Kabelkanal 22 weist eine durchgehende, zum Innenraum des Containers gerichtete Öffnung 40 auf und ermöglicht derart das Einlegen und Führen von elektrischen Leitungen, die innerhalb des Einzelcontainers 1 zwischen den einzelnen Komponenten zu verlegen sind.

Der nasenförmige, umlaufende Dichtkragen 39 drückt gegen ein im Deckel 41 eingelegtes Dichtprofil, welches beispielsweise aus Gummi besteht. Auf diese Art wird eine sehr gute Dichtwirkung erzielt.

Der umlaufende Flansch 26 dient zum einen zur Befestigung der Rückwand 42, wobei vorzugsweise ein eingelegtes Dichtprofil für die Abdichtung des Gehäuseinnenraums vorgesehen ist, zum anderen werden über diesen Flansch 26 die Kräfte der installierten Komponenten in die Gehäusestruktur eingeleitet.

## Patentansprüche

1. Unterflurcontainer eines Schienenfahrzeuges für elektrische Komponenten, der modulartig in mehrere Einzelcontainer (1 bis 4) unterteilt ist, die miteinander mechanisch verbunden und zum Zwecke der Kühlung thermisch in Reihe geschaltet sind, **dadurch gekennzeichnet, dass**
- die Reihenschaltung eingangsseitig zwei thermisch parallel geschaltete Einzelcontainer (2, 3) aufweist und
- die Reihenschaltung ferner einen mit einem Lüfter (15) versehenen Einzelcontainer (1, 4) aufweist, wobei der Lüfter (15) Kühlluft aus den zwei thermisch parallel geschalteten Einzelcontainern (2, 3) ansaugt wobei die zwei thermisch parallel geschalteten Einzelcontainer (2, 3) an gegenüberliegenden Seiten des mit dem Lüfter versehenen, mittleren Einzelcontainers (1) vorhanden sind, wobei der Lüfter die Kühlluft direkt in die Umgebung abführt.

2. Unterflurcontainer eines Schienenfahrzeuges für elektrische Komponenten, der modulartig in mehrere Einzelcontainer (1 bis 4) unterteilt ist, die miteinander mechanisch verbunden und zum Zwecke der Kühlung thermisch in Reihe geschaltet sind, **dadurch gekennzeichnet, dass**
- die Reihenschaltung eingangsseitig zwei thermisch parallel geschaltete Einzelcontainer (2, 3) aufweist und
- die Reihenschaltung ferner einen mit einem Lüfter (15) versehenen Einzelcontainer (1, 4) aufweist, wobei der Lüfter (15) Kühlluft aus den zwei thermisch parallel geschalteten Einzelcontainern (2, 3) ansaugt, wobei die zwei thermisch parallel geschalteten Einzelcontainer (2, 3) an gegenüberliegenden Seiten eines mittleren Einzelcontainers (1) vorhanden sind, wobei an einer dritten Seite des mittleren Einzelcontainers ein weiterer mit dem mittleren Einzelcontainer (1) thermisch in Reihe geschalteten Einzelcontainer (4) vorgesehen ist, wobei der Lüfter im mittleren oder im weiteren Einzelcontainer vorhanden ist und wobei die Einzelcontainer (1 bis 4) Öffnungen (13, 14) aufweisen und induziert vom Lüfter (15) hierdurch von Kühlluft durchströmt werden.

3. Unterflurcontainer nach mindestens einem der vorherigen Ansprüche, **dadurch gekennzeichnet, dass** die Einzelcontainer (2, 3) mittels Tragschienen (7, 8) miteinander verbunden sind.

4. Unterflurcontainer eines Schienenfahrzeuges für elektrische Komponenten, der modulartig in mehrere Einzelcontainer (1 bis 3) unterteilt ist, die miteinander mechanisch verbunden und zum Zwecke der Kühlung thermisch in Reihe geschaltet sind, **dadurch gekennzeichnet, dass**
- ein erster (1), ein zweiter (2) und ein dritter (3) dieser Einzelcontainer mittels Tragschienen (7, 8) miteinander verbunden sind, und
- die Tragschienen zur Befestigung des Unterflurcontainers an dem Schienenfahrzeug dienen.

5. Unterflurcontainer nach Anspruch 4, **dadurch gekennzeichnet, dass** der zweite und der dritte Einzelcontainer (2, 3) an gegenüberliegenden Seiten des ersten Einzelcontainers (1) vorhanden sind, wobei an einer dritten Seite des ersten Einzelcontainers ein vierter Einzelcontainer (4) vorgesehen ist, wobei im ersten oder im vierten Einzelcontainer (1, 4) ein Lüfter (15) angeordnet ist, und wobei die Einzelcontainer (1 bis 4) Öffnungen (13, 14) aufweisen und induziert vom Lüfter (15) hierdurch von Kühlluft durchströmt werden.

6. Unterflurcontainer nach mindestens einem der Ansprüche 4 oder 5, **dadurch gekennzeichnet, dass** die Reihenschaltung eingansseitg zwei thermisch parallel geschaltete Einzelcontainer aufweist, die aus dem zweiten (2) und dem dritten (3) Einzelcontainer bestehen.

7. Unterflurcontainer nach mindestens einem der vorherigen Ansprüche, **dadurch gekennzeichnet, dass** die Einzelcontainer (1 bis 4) im wesentlichen die gleiche Bauhöhe aufweisen.

8. Unterflurcontainer nach mindestens einem der vorherigen Ansprüche, **dadurch gekennzeichnet, dass** die Einzelcontainer (1 bis 4) Wandungen aus Strangpressprofilen mit offenen und geschlossenen Kanälen aufweisen.

## Claims

1. Underfloor container of a rail vehicle for electric components, wherein the underfloor container is divided in a modular manner into a plurality of individual containers (1 to 4) which are connected mechanically to one another and are thermally connected in series for cooling purposes, **characterised in that**:
- the series connection has, on the input side, two individual containers (1, 2) which are thermally connected in parallel,
- the series connection further includes an individual container (1, 4) provided with a fan (15), which sucks cooling air from the two individual containers (1, 2) which are thermally connected in parallel, wherein the two individual containers (1, 2) which are thermally connected in parallel are arranged on opposite sides of the central individual container (1) provided with the fan (15), and the fan (15) rejects the cooling air directly in the atmosphere.

2. Underfloor container of a rail vehicle for electric components, wherein the underfloor container is divided in a modular manner into a plurality of individual containers (1 to 4) which are connected mechanically to one another and are thermally connected in series for cooling purposes, **characterised in that**:
- the series connection has, on the input side, two individual containers (1, 2) which are thermally connected in parallel,
- the series connection further includes an individual container (1, 4) provided with a fan (15), which sucks cooling air from the two individual containers (1, 2) which are thermally connected in parallel, wherein the two individual containers (1, 2) which are thermally connected in parallel are arranged on opposite sides of a central individual container (1), wherein a further individual container (4) is provided on a third side of the central individual container (1) and thermically connected in series with the central individual container (1), wherein the fan is arranged in the central or further individual container (1, 4), whererin the individual containers (1 to 4) have openings (13, 14) and, induced by the fan (15), cooling air thereby flows through them.

3. Underfloor container according to at least one of the preceding Claims, **characterized in that** the individual containers (2, 3) are connected to one another by means of supporting rails (7, 8).

4. Underfloor container of a rail vehicle for electric components, wherein the underfloor container is divided in a modular manner into a plurality of individual containers (1 to 4) which are connected mechanically to one another and are thermally connected in series for cooling purposes, **characterised in that**:
- a first (1), a second (2) and a third (3) of the individual containers are connected to one another by means of supporting rails (7, 8),
- the supporting rails (7, 8) are used to attach the underfloor container to the rail vehicle.

5. Underfloor container according to at least one of Claims 1 to 4, **characterized in that** the second (2) and third (3) individual container are arranged on opposite sides of the first individual container (1), wherein a fourth individual container (4) is provided on a third side of the first individual container (1), wherein a fan is arranged in the first or fourth individual container (1, 4), whererin the individual containers (1 to 4) have openings (13, 14) and, induced by the fan (15), cooling air thereby flows through them.

6. Underfloor container according to at least one of Claims 4 or 5, **characterized in that** the series connection has, on the input side, two individual containers thermally connected in parallel, which are constituted by the second (2) and third (3) individual containers.

7. Underfloor container according to at least one of the preceding Claims, **characterized in that** the individual containers (1 to 4) have essentially the same overall height.

8. Underfloor container according to at least one of the preceding Claims, **characterized in that** the individual containers (1 to 4) have walls made from extruded profiles with open and closed channels.

## Revendications

1. Conteneur sous plancher d'un véhicule ferroviaire, pour des composants électriques, le conteneur étant divisé de façon modulaire en plusieurs conteneurs individuels (1 à 4) qui sont reliés mécaniquement les uns aux autres et qui sont raccordés thermiquement en série en vue de leur refroidissement, **caractérisé en ce que**
- le raccordement en série présente du côté de son entrée deux conteneurs individuels (1, 2) raccordés thermiquement en parallèle et
- le raccordement en série présente en outre un conteneur individuel (1, 4) pourvu d'un ventilateur (15), le ventilateur (15) aspirant de l'air de refroidissement des deux conteneurs individuels (2, 3) raccordés thermiquement en parallèle, les deux conteneurs individuels (2, 3) raccordés thermiquement en parallèle étant disposés sur des cotés opposés du conteneur central (1) pourvu du ventilateur, le ventilateur rejetant l'air de refroidissement directement dans l'environnement.

2. Conteneur sous plancher d'un véhicule ferroviaire, pour des composants électriques, le conteneur étant divisé de façon modulaire en plusieurs conteneurs individuels (1 à 4) qui sont reliés mécaniquement les uns aux autres et qui sont raccordés thermiquement en série en vue de leur refroidissement **caractérisé en ce que**
- le raccordement en série présente du côté de son entrée deux conteneurs individuels (1, 2) raccordés thermiquement en parallèle et
- le raccordement en série présente en outre un conteneur individuel (1, 4) pourvu d'un ventilateur (15), le ventilateur (15) aspirant de l'air de refroidissement des deux conteneurs individuels (2, 3) raccordés thermiquement en parallèle, les deux conteneurs individuels (2, 3) raccordés thermiquement en parallèle étant disposés de des côtés opposés d'un conteneur central (1), un conteneur individuel additionnel (4) étant disposé sur un troisième côté du conteneur individuel central thermiquement en série avec le conteneur individuel central, le ventilateur étant disposé dans le conteneur individuel central (1) ou le conteneur individuel additionnel (4), les conteneurs individuels (1 à 4) étant pourvus d'ouvertures (13, 14), au travers desquelles un courant d'air de refroidissement est induit par le ventilateur (15) et traverse les conteneurs individuels.

3. Conteneur sous plancher selon au moins l'une des revendications précédentes, **caractérisé en ce que** les conteneurs individuels (1 à 4) sont reliés les uns aux autres au moyen de rails de support (7, 8).

4. Conteneur sous plancher d'un véhicule ferroviaire, pour des composants électriques, le conteneur étant divisé de façon modulaire en plusieurs conteneurs individuels (1 à 3) qui sont reliés mécaniquement les uns aux autres et qui sont raccordés thermiquement en série en vue de leur refroidissement **caractérisé en ce que** :
- un premier (1), un deuxième (2) et un troisième (3) de ces conteneurs individuels sont reliés les uns aux autres par des rails de support (7, 8), et
- les rails de support servent à fixer le conteneur sous plancher au véhicule ferroviaire.

5. Conteneur sous plancher selon la revendication 4, **caractérisé en ce que** le deuxième et le troisième conteneurs individuels (2, 3) sont disposés sur des côtés opposés du premier conteneur individuel (1), un quatrième conteneur individuel (4) étant disposé sur un troisième côté du premier conteneur individuel, un ventilateur (15) étant disposé dans le premier ou le quatrième conteneur individuel (1, 4), les conteneurs individuels (1 à 4) étant pourvus d'ouvertures (13, 14), au travers desquelles un courant d'air de refroidissement est induit par le ventilateur (15) et traverse les conteneurs individuels.

6. Conteneur sous plancher selon au moins l'une des revendications 4 ou 5, **caractérisé en ce que** le raccordement en série présente du côté de son entrée deux conteneurs individuels raccordés thermiquement en parallèle, qui sont constitués par le deuxième (2) et le troisième (3) conteneurs individuels.

7. Conteneur sous plancher selon au moins l'une des revendications précédentes, **caractérisé en ce que** les conteneurs individuels (1 à 4) présentent essentiellement la même hauteur.

8. Conteneur sous plancher selon au moins l'une des revendications précédentes, **caractérisé en ce que** les conteneurs individuels (1 à 4) présentent des parois constituées de profilés extrudés dotés de canaux ouverts et de canaux fermés.
